# EUROPEAN PATENT APPLICATION

(11) **EP 4 641 722 A1**
(43) Date of publication of application: **29.10.2025**
(21) Application number: 24222833.6
(22) Date of filing: 23.12.2024
(51) Int. Cl.: H01M 10/04, H01M 10/42, G01R 31/52

(54) **INTERNAL SHORT-CIRCUIT DEVICE FOR BATTERY AND METHOD OF MANUFACTURING AN INTERNAL SHORT-CIRCUIT DEVICE FOR A BATTERY**

(30) Priority: 25.04.2024 KR 20240055698
(71) Applicant: SAMSUNG SDI CO., LTD., Yongin-si, Gyeonggi-do 17084 (KR)
(72) Inventor: Lee, Sang Hyo, 17084 Yongin-Si Gyeonggi-do (KR); Lim, Cheahyun, 17084 Yongin-Si Gyeonggi-do (KR)
(74) Representative: Gulde & Partner

(57) **Abstract**

An internal short-circuit device (100, 200, 300, 810) includes an insulating member (110, 516, 526, 621, 641, 661, 910) including a hole (112, 518, 538), a short-circuit inducing portion (132, 412, 422, 432, 514, 614, 634, 654, 932) of a first electrode plate (130, 512, 611, 631, 651) for a battery (800) extending through the hole (112, 518, 538) in the insulating member (110, 516, 526, 621, 641, 661, 910), and an insulating layer (120, 220, 920) disposed between the insulating member (110, 516, 526, 621, 641, 661, 910) and a second electrode plate (130, 140) for the battery (800). A first surface (121) of the insulating layer (120, 220, 920) is in contact with the short-circuit inducing portion (132, 412, 422, 432, 514, 614, 634, 654, 932) of the first electrode plate (130, 512, 611, 631, 651), and a second surface (122) of the insulating layer (120, 220, 920), which is opposite to the first surface (121), is in contact with the second electrode plate (130, 140).

## Description

### BACKGROUND

### Field

Aspects of embodiments of the present disclosure relate to an internal short-circuit device for a battery and a method of manufacturing an internal short-circuit device for a battery.

### Description of the Related Art

Unlike primary batteries that are not designed to be (re)charged, secondary (or rechargeable) batteries are designed to be discharged and recharged.
Low-capacity secondary batteries are used in portable, small electronic devices, such a s smart phones, feature phones, notebook computers, digital cameras, and camcorders. Large-capacity secondary batteries are widely used as power sources for driving motor s in hybrid vehicles and electric vehicles and for storing power (e.g., home and/or utilit y scale power storage). A secondary battery includes an electrode assembly that includes a positive electrode and a negative electrode, a case accommodating the electrode assembly, and electrode terminals connected to the electrode assembly.

Secondary (rechargeable) batteries, due to their excellent electrical characteristics, are used in various environments. However, in abnormal conditions such as overcharging, over-discharging, exposure to high temperatures, or physical impacts, the stability of secondary batteries decreases. Therefore, various developments have been made to improve the reliability of the secondary batteries. In particular, an internal short-circuit where a direct electrical connection occurs between the positive and negative electrodes inside the secondary battery due to the rupture of the separator can generate heat within the battery, causing a rapid release of electrical energy, potentially leading to explosions or fires.

Therefore, ensuring the safety of the battery in the event of an internal short-circuit is significantly important. Many modern secondary batteries include safety devices to prevent explosions or fires even when a short-circuit occurs. To enhance the reliability of batteries in real-world situations, it is essential to accurately assess the safety during the battery development process when an internal short-circuit occurs. Conventionally, internal short-circuits have been implemented by inserting an additional metal layer to reduce the short-circuit resistance and induce ignition to verify the safety. However, this method struggles to reproduce the form of internal short-circuits in a low-voltage mode where the positive and negative electrode plates come into contact due to damage to the separator, which most commonly occurs during typical battery usage.

The above information disclosed in this Background section is for enhancement of understanding of the background of the present disclosure, and theref ore, it may contain information that does not constitute related (or prior) art.

### SUMMARY

The invention is defined by the appended claims. The description that follows is subjected to this limitation. Any disclosure lying outside the scope of said claims is only intended for illustrative as well as comparative purposes.

Embodiments of the present disclosure provide an internal short-circuit device for a battery and a method of evaluating the reliability of the battery having an internal short-circuit device.

Aspects of embodiments provide an internal short-circuit device. The internal short-circuit device includes an insulating member including a hole, a short-circuit inducing portion of a first electrode plate of a battery extending through the hole in the insulating member; and an insulating layer disposed between the insulating member and a second electrode plate of the battery. A first surface of the insulating layer is in contact with the short-circuit inducing portion of the first electrode plate, and a second surface of the insulating layer, which is opposite to the first surface, is in contact with the second electrode plate.

In other words, the internal short-circuit device may include an insulating layer disposed or disposable between the insulating member and the second electrode plate of the battery to insulate the first electrode and the insulating member from the second electrode in a first state. In a second state, the insulation is affected, for example removed, such that the first electrode and the second electrode are electrically connectable. The internal short-circuit device may be configured to change from the first to the second state and to establish an electrically connection between the first electrode plate and the second electrode plate in the second state. The insulating member may be configured to guide the short-circuit inducing portion such that the insulating layer and the short-circuit inducing portion can contact each other in the second state.

According to one embodiment, the short-circuit inducing portion may be electrically connected or connectable to the first electrode plate. In other words, the first electrode plate may not be a component of the internal short-circuit device but may be electrically connected or connectable to the short-circuit inducing portion.

According to one embodiment, the short-circuit inducing portion may be a portion of the first electrode plate for a battery that is electrically connected to the first electrode plate. The short-circuit inducing portion may include the same structure and be made from the same material as the first electrode plate.

According to one embodiment, the internal short-circuit device may further include the first electrode plate for a battery, wherein the first electrode plate has the short-circuit inducing portion, and/or the second electrode plate for the battery. In other words, the internal short-circuit device may include the first electrode plate, but the first electrode may be alternatively be electrically connectable to the short-circuit inducing portion, such that the first electrode plate is no part of the internal short-circuit device in the latter case. The same applies the battery, which may be part of the internal short-circuit device or alternatively, the internal short-circuit device may be configured for use and assembly in the battery.

According to one embodiment, the insulating member may be a ring, a washer, or a square-hole shaped auxiliary component that includes the hole.

According to one embodiment, the hole may be formed in various shapes such as a circle or a square. According to one embodiment, the shape and size of the hole may be configured to ensure that the short-circuit inducing portion is not shaken by an external impact to the battery. According to one embodiment, the short-circuit inducing portion may have cross-section corresponding to the shape of the hole.

According to one embodiment, at least a portion of the short-circuit inducing portion may be disposed between the insulating member and the insulating layer.

According to one embodiment, to facilitate an alignment, the insulating layer may have adhesive properties, such as those of insulation wax. Therefore, it can adhere to the short-circuit inducing portion and/or the second electrode plate.

According to one embodiment, at least a portion of a contact area between the first surface of the insulating layer and the short-circuit inducing portion may have a coating including an adhesive to secure the insulating layer and the short-circuit inducing portion together.

According to one embodiment, at least a portion of a contact area between the second surface of the insulating layer and the second electrode plate may have a coating including an adhesive to secure the insulating layer and the second electrode plate together.

According to one embodiment, a separator may be disposed between the first electrode plate and the second electrode plate of the battery, and the insulating layer may be coated on a surface of the second electrode plate corresponding to a cut-out portion of the separator. In other words, the insulating layer may include a coating disposed at least in a cut-out portion, wherein the cut-out portion is in other words a cut-out or a recess of the separator such that the second electrode is separator-free in the region of the cut-out. The insulating layer may overlap the sides of the separator defined by the cut-out. In other words, the insulating layer may have a T-shape. In other words, the insulating member may be a filling at least in a cut-out portion.

According to one embodiment, the internal short-circuit device may further include the separator for a battery.

According to one embodiment, the thickness of the insulating layer may be set to be greater than the thickness of the separator in order to maintain an insulation state prior to a short-circuit and to facilitate a subsequent short-circuit.

According to one embodiment, in order to prevent the occurrence of an unintentional internal short-circuit, the area of the cut-out portion of the separator may be set to be less than the area of the insulating layer. The thickness of the insulating layer may range from 0.01 to 0.1 mm in order to maintain insulation performance.

According to one embodiment, at least a portion of the insulating member may be disposed between the first electrode plate and the separator.

According to one embodiment, the short-circuit inducing portion may be a portion cut from the first electrode plate. In other words, the short-circuit inducing portion may be a cut portion or cut-out portion of the first electrode plate. In this context, cut-out means that a part of the first electrode plate is cut out but a connection of the cut part to the first electrode plate is maintained. The internal short-circuit device may include the first electrode plate.

According to one embodiment, the short-circuit inducing portion of the first electrode plate may include a substrate, an upper active material layer disposed on a top surface of the substrate, and a lower active material layer disposed on a bottom surface of the substrate, and the substrate may be in contact with the insulating layer.

According to one embodiment, the short-circuit inducing portion of the first electrode plate may include a substrate, an upper active material layer disposed on a top surface of the substrate, and a lower active material layer disposed on a bottom surface of the substrate, and the lower active material layer may be in contact with the insulating layer.

According to one embodiment, the insulating layer may be formed from a paraffin-based compound having 1 to 50 carbon atoms. In other words, the insulating may layer comprise a material which is a paraffin-based compound having from 1 to 50 carbon atoms. The insulating layer may consist of this material.

According to one embodiment, the insulating layer may be configured to melt when its temperature rises above a predefined threshold, for example, by external heating during safety testing of the battery or as result of heat generation due to chemical reactions during the actual charging and discharging process of the battery. The state, in which the insulating layer is not melted may refer to the first state, and the state, in which the insulating layer is melted may refer to the second state.

According to one embodiment, an external pressure may be applied to the internal short-circuit device causing the first electrode plate to come into contact with and be electrically connected to the second electrode plate, when the insulating layer melts, resulting in the internal short-circuit. In other words, the first electrode plate may be configured to come into contact with and be electrically connected to the second electrode plate when an external pressure is applied to the internal short-circuit device, when the insulating layer is melted.

According to one embodiment, a melting point of the insulating layer may be in a range from 45°C to 70°C. The melting point of the insulating layer may be in a range from 50°C to 65°C or from 55°C to 60°C.

According to one embodiment, the battery may be formed by winding the first electrode plate and the second electrode plate in a stacked state such that the first electrode plate and the second electrode plate are electrically connected to each other when the insulating layer is melted. In other words, in the embodiment, in which the internal short-circuit device may further include the first electrode plate for a battery with the short-circuit inducing portion and the second electrode plate for the battery, the battery may include the first electrode plate and the second electrode plate in a winded and stacked state such that the first electrode plate and the second electrode plate are electrically connected to each other when the insulating layer is melted. This may correspond to the second state.

According to one embodiment, a length of the hole may correspond to a length of the short-circuit inducing portion. For example, the length of the hole may correspond to or be greater than the length of the short-circuit inducing portion such that one end of the short-circuit inducing portion passes through the hole and contacts the insulating layer.

According to one embodiment, a width of the hole may correspond to a thickness of the short-circuit inducing portion. For example, the width of the hole may correspond to or be greater (longer) than the thickness of the short-circuit inducing portion such that one end of the short-circuit inducing portion passes through the hole and contacts the insulating layer.

According to one embodiment, an area of the hole may correspond to or be larger than a cross-sectional area of the short-circuit inducing portion.

According to one embodiment, a length of the hole may range from 3 mm to 9 mm. The length of the hole may range from 4 mm to 8 mm or from 5 mm to 7 mm.

According to one embodiment, a height of the insulating member may range from 0.05 mm to 0.5 mm. The height of the insulating member may range from 0.10 mm to 0.4 mm or from 0.15 mm to 0.35 mm. The height may refer to a direction extending between the first electrode and the second electrode. In other words, the height may also refer to a thickness of the insulating member, in other words its smaller extension.

According to one embodiment, the short-circuit inducing portion may be located at an end of the first electrode plate. The end may refer to the to the longer sides of the first electrode plate.

According to one embodiment, the short-circuit inducing portion may be located at a side surface of the first electrode plate. The side surface may refer to the longer sides of the first electrode plate.

According to one embodiment, the short-circuit inducing portion may be located at a middle region of the first electrode plate. The middle region may refer to a middle area between the longer sides of the first electrode plate.

According to one embodiment, the short-circuit inducing portion may also be located at an intermediate position between said locations. The short-circuit inducing portion may also located at an edge portion, which may be considered as a combination of a location at a side surface and at an end.

According to one embodiment, the short-circuit inducing portion may be formed by perforating a portion of the first electrode plate into a U-shape. In other words, the first electrode plate may include a perforated portion of the first electrode plate with a U-shape.

Aspects of embodiments further provide a method of manufacturing an internal short-circuit device. The method includes forming a short-circuit inducing portion of a first electrode plate of a battery, passing the short-circuit inducing portion through a hole in an insulating member, cutting a portion of a separator arranged between the first electrode plate and a second electrode plate to expose at least a portion of the second electrode plate through the cut-out portion of the separator, coating an insulating layer on a surface of the second electrode plate at a position corresponding to the cut-out portion of the separator; and contacting the short-circuit inducing portion, which has passed through the hole, to the insulating layer.

According to one embodiment, the forming of the short-circuit inducing portion may include cutting a portion of the first electrode plate.

According to one embodiment, the method may further include removing an active material layer of the short-circuit inducing portion to expose a substrate of the short-circuit inducing portion prior to the contacting of the short-circuit inducing portion with the insulating layer.

Aspects of embodiments further provide a battery including the internal short-circuit device according to one embodiment of the present disclosure as well as the first electrode plate, the second electrode plate and the separator.

According to some embodiments of the present disclosure, the internal short-circuit mode, which most frequently occurs due to direct contact between the positive electrode and the negative electrode, can be accurately implemented by heating at a relatively low temperature without external deformation of the battery. Additionally, the short circuit between the positive electrode and the negative electrode of an actual cell can be reproduced without the need for a separate metallic electrical short path. This allows for precise safety evaluation when an internal short-circuit occurs during the battery development process, thereby improving the reliability of the battery and the reproducibility of the safety devices.

According to some embodiments of the present disclosure, it is possible to provide a structure of the internal short-circuit device that allows for the adjustment of short-circuit resistance and length as needed. This structure enables the reproduction of various internal short-circuit modes within the battery, including different locations, different shapes, and different lengths.

Further, according to some embodiments of the present disclosure, the safety evaluation method of a battery can implement a low-voltage mode of the battery caused by an internal short-circuit by implementing an actual short path. Furthermore, in the low-voltage mode of the battery, the sectional short-circuit resistance can be calculated based on the amount of voltage reduction over time, and the degree of Joule heating corresponding to the calculated internal short-circuit resistance can be determined. This provides a method to evaluate and predict the safety of a battery, thereby increasing the reliability of evaluations to develop or implement safety devices.

However, aspects and features of the present disclosure are not limited to thos e described above, and other aspects and features not mentioned will be clearly understood by a person skilled in the art from the detailed description, described below.

### BRIEF DESCRIPTION OF DRAWINGS

The following drawings attached to the present specification illustrate embodiments of the present disclosure, and further describe aspects and features of the present disclosure together with the detailed description of the present disclosure. Thus, the present disclosure should not be construed as being limited to the drawings:
FIG. 1 is a schematic diagram illustrating an internal short-circuit device before heating according to an embodiment of the present disclosure.
FIG. 2 is a schematic diagram illustrating an internal short-circuit device after heating according to an embodiment of the present disclosure.
FIG. 3 is a schematic diagram illustrating an internal short-circuit device according to an embodiment of the present disclosure.
FIGS. 4 to 6 are diagrams illustrating short-circuit inducing portions according to an embodiment of the present disclosure.
FIGS. 7 to 9 are diagrams illustrating shapes of an insulating member and a hole according to one embodiment of the present disclosure.
FIGS. 10 to 12 are diagrams illustrating a location of a short-circuit inducing portion according to an embodiment of the present disclosure.
FIG. 13 is a flowchart of a method of manufacturing an internal short-circuit device according to an embodiment of the present disclosure.
FIG. 14 is a diagram illustrating a battery according to one embodiment of the present disclosure.
FIG. 15 is a diagram illustrating a part of a cross-section of a battery according to an embodiment of the present disclosure.
FIGS. 16 and 17 are graphs illustrating results of verifying an internal short-circuit in a battery according to an embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent wi th the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various eq uivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening el ements or layers may also be present. When an element or layer is referred to as bei ng "directly on," "directly connected to," or "directly coupled to" another element or laye r, there are no intervening elements or layers present. For example, when a first element is described as being "coupled" or "connec ted" to a second element, the first element may be directly coupled or connected to th e second element or the first element may be indirectly coupled or connected to the s econd element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of " and "any one of," when preceding a list of elements, modify the entire list of elemen ts and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may r efer to any and all suitable combinations or a subset of A, B and C, such as A, B, C , A and B, A and C, B and C, or A and B and C. As used herein, the terms "use," " using," and "used" may be considered synonymous with the terms "utilize," "utilizing," a nd "utilized," respectively. As used herein, the terms "substantially," "about," and similar terms are used as terms of approximation and not as terms of degree, and are intended to account for the inhere nt variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one elemen t, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," a nd the like, may be used herein for ease of description to describe one element or fe ature's relationship to another element(s) or feature(s) as illustrated in the figures. It will be understood that the spatially relative terms are intended to encompass different orientations of the device in use or operation in a ddition to the orientation depicted in the figures. For example, if the device in the figures is turned over, elements described as "below" or "beneath" other elements or features would then be oriented "above" or "over" the other elements or fe atures. Thus, the term "below" may encompass both an orientation of above and below. The device may be otherwise oriented (rotated 90 deg rees or at other orientations), and the spatially relative descriptors used herein should be interpreted accordingly.

The terminology used herein is for the purpose of describing embodiments of the present disclosure and is not intended to be limiting of the presen t disclosure. As used herein, the singular forms "a" and "an" are intended to include the plural forms as well, unless the context clearly indicates otherw ise. It will be further understood that the terms "includes," "including," "comprises," and/or "comprising," when used in this specification, specify the presence of stated features, integers, steps, operations, elements, and/or components but do not preclude the presence or addition of one or more other feature s, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for examp le, 2.4 to 7.6. Any maximum numerical limitation recited herein is intended to include all lower numerical limitations subsumed therein, and any minimum numerical limitation recited in this specification is intended to include all highe r numerical limitations subsumed therein. Accordingly, Applicant reserves the right to a mend this specification, including the claims, to expressly recite any sub-range subsumed within the ranges expressly recited herein. All such ranges are intended to be inherently described in this specification such that amending to expressly recite any such subranges would comply with the requirements of 35 U. S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that i t is uniform in terms of an average.

Throughout the specification, unless otherwise stated, each element may be sin gular or plural.

When an arbitrary element is referred to as being disposed (or located or posit ioned) on the "above (or below)" or "on (or under)" a component, it may mean that the arbitrary element is placed in contact with the upper (or lower) surf ace of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "co upled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each othe r.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

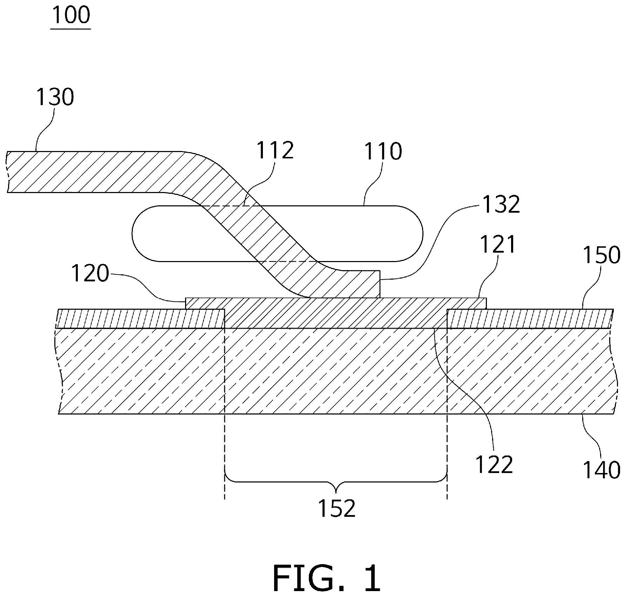

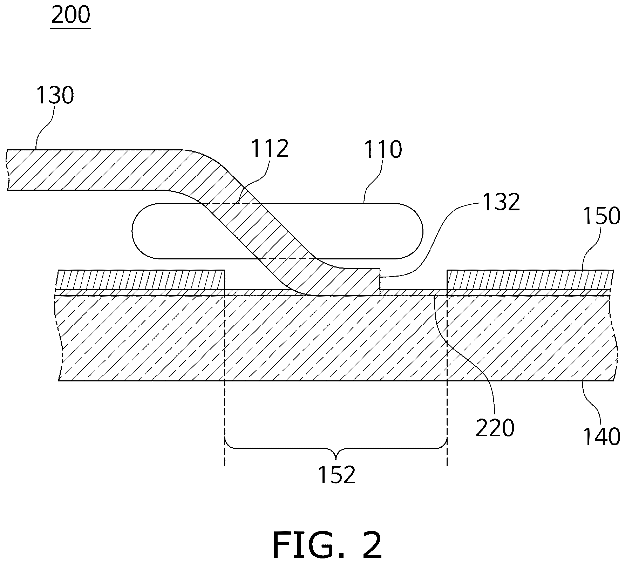

FIG. 1 is a schematic diagram illustrating an internal short-circuit device 100 before heating according to one embodiment of the present disclosure. FIG. 2 is a schematic diagram illustrating an internal short-circuit device 200 after heating according to one embodiment of the present disclosure.

Referring to FIG. 1, the internal short-circuit device 100 or 200 of a battery according to one embodiment of the present disclosure may include an insulating member 110 including a hole 112 through which a short-circuit inducing portion 132 of a first electrode plate 130 of the battery passes, and an insulating layer 120 disposed between the insulating member 110 and a second electrode plate 140 of the battery. Here, the battery may be a type of secondary battery.

The first electrode plate 130 of the battery may be an electrode plate corresponding to a positive electrode or a negative electrode of the battery. The second electrode plate 140 of the battery may be an electrode plate corresponding to an electrode of the opposite polarity to the first electrode plate 130 of the battery. For example, if the first electrode plate 130 of the battery is the positive electrode plate, then the second electrode plate 140 of the battery may be the negative electrode plate. Conversely, if the first electrode plate 130 of the battery is the negative electrode, then the second electrode plate 140 of the battery may be the positive electrode. The negative electrode plate may be made of copper (Cu), and the positive electrode plate may be made of aluminum (Al).

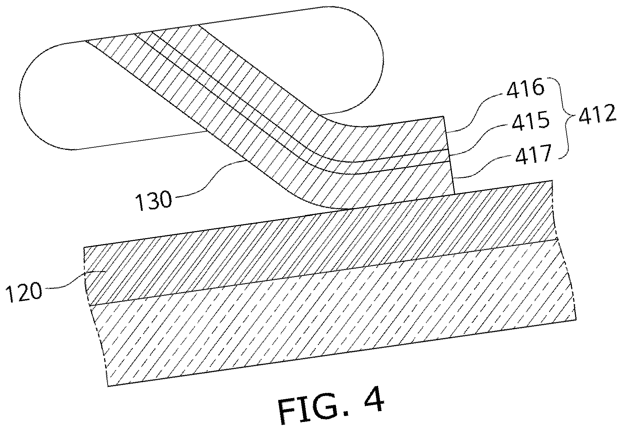

At least one of the first electrode plate 130 and the second electrode plate 140 may include a substrate, an upper active material layer disposed on a top surface of the substrate, and a lower active material layer disposed on a bottom surface of the substrate. The short-circuit inducing portion 132 may be a portion of the first electrode plate 130 that is electrically connected to the first electrode plate 130, and the short-circuit inducing portion 132 may include the same structure and be made from the same material as the first electrode plate 130. The short-circuit inducing portion 132 may be formed, for example, by cutting a portion of the first electrode plate 130. The method for forming and positioning of the short-circuit inducing portion 132 will be described in detail with reference to FIGS. 4 to 6 and 10 to 12.

In one embodiment, a separator 150 is disposed between the first electrode plate 130 and the second electrode plate 140 of the battery, and the insulating layer 120 is coated on a surface of the second electrode plate 140 corresponding to a cut-out portion of the separator 150.

The separator 150 may be configured to be located between the first electrode plate 130 and the second electrode plate 140 of the battery to prevent a short-circuit due to direct contact of the plates 130 and 140 and to enable the movement of ions. The separator 150 may include any of the following materials: polyethylene (PE), polyvinylidene fluoride (PVDF), polyacrylonitrile (PAN), polyethylene oxide (PEO), or polypropylene (PP). However, the present disclosure is not limited to such materials, and the separator 150 may be any other suitable compound known in the art for use as a separator in batteries.

In one embodiment, a portion of the separator 150 may be cut to induce an internal short-circuit. A location of a cut-out portion of the separator 150 may substantially correspond to a location where the user intends to attach the short-circuit device 100. However, the location of the cut-out portion of the separator 150 is not limited thereto, and the location of the cut-out portion may be varied depending, for example, to facilitate inducing an internal short-circuit for safety evaluation. The method of cutting the separator 150 is not limited and may include a perforation cutting method to minimize damage to the first electrode plate or the second electrode plate. In order to prevent the occurrence of an unintentional internal short-circuit, the area of the cut-out portion of the separator 150 may be set to be less than the area of the insulating layer 120. For example, if the cut-out portion of the separator 150 has the length of 6 mm and the width of 2 mm, the insulating layer 120 may have the length of 10 mm or more and the width of 4 mm or more.

The insulating member 110 may guide the short-circuit inducing portion 132 such that the insulating layer 120 and the short-circuit inducing portion 132 can contact each other. More specifically, the short-circuit inducing portion 132 may be configured to pass through the hole 112 in the insulating member 110 such that one end of the short-circuit inducing portion 132 comes into contact with the insulating layer 120.

In one embodiment, at least a portion of the insulating member 110 may be positioned between the first electrode plate 130 and the separator 150. As a result, the first electrode plate 130 may be spaced from the separator 150 by the height of the insulating member 110 in the area around the cut-out portion 152 of the separator 150.

The area of the separator 150 around the cut-out portion 152 has low mechanical strength and is therefore susceptible to breaking. By providing the insulating member 110, the first electrode plate 130 may be separated from the separator 150, thereby preventing breakage of the separator 150 and ensuring that an internal short-circuit occurs only within the intended area or length. Further, the insulating member 110 may guide the short-circuit inducing portion 132 to reach and remain at a targeted position.

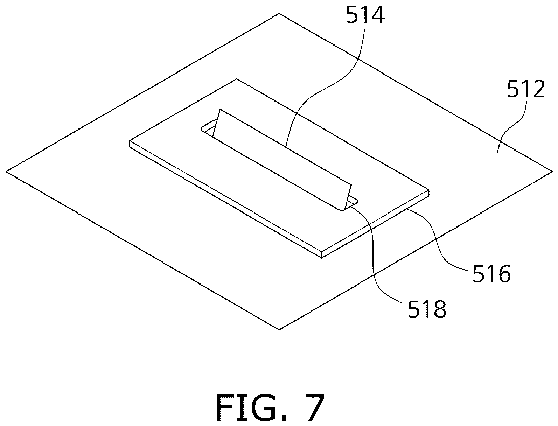

The insulating member 110 may be a ring, a washer, or a square-hole shaped auxiliary component that includes the hole 112. That is, the hole 112 may be formed in various shapes such as a circle or a square. In one embodiment, the shape and size of the hole 112 may be configured to ensure that the short-circuit inducing portion 132 is not shaken by an external impact to the battery. For example, if the short-circuit inducing portion 132 has a narrow rectangular cross-section, the shape of the hole 112 may also have a similar narrow rectangular shape. However, the present disclosure is not limited thereto, and various examples of shapes of the hole 112 and the insulating member 110 will be described later with reference to FIGS. 7 to 9.

In one embodiment, the height of the insulating member 110 may range from 0.05 mm to 0.5 mm. In a case where the height of the insulating member 110 is less than 0.05 mm, the internal short-circuit device 100 may easily move out of the designated position. On the other hand, in a case where the height of the insulating member 110 exceeds 0.5 mm, the thickness of a portion where the internal short-circuit device 100 is located may be excessively thick, which may lead to high pressure being applied to the separator 150, which may cause portions other than the cut-out portion 152 to break. Further, if the height of the insulating member 110 exceeds 0.5 mm, a surface of the hole 112 of the insulating member 110 may exert pressure on the first electrode plate 130, causing the first electrode plate 130 to be broken.

In one embodiment, the insulating member 110 may be made of ceramic materials or polymer materials such as polyvinyl chloride (PVC), polytetrafluoroethylene (PTFE or TEFLON^{®}), polyethylene (PE), epoxy resin, silicone, polyvinylidene fluoride (PVDF), polypropylene (PP), polyacrylonitrile (PAN), or polyethylene oxide (PEO). However, the present disclosure is not limited to such materials, and the insulating member 110 may be any suitable compound known in the art for use as an insulating material.

In one embodiment, at least a portion of the short-circuit inducing portion 132 may be disposed between the insulating member 110 and the insulating layer 120. As shown in FIG. 2, when the insulating layer 120 is melted by heat, the insulating member 110 may press at least the portion of the short-circuit inducing portion 132 such that the short-circuit inducing portion 132 comes into contact with the second pole plate 140.

A first surface (or a top surface) 121 of the insulating layer 120 may be in contact with the short-circuit inducing portion 132 of the first electrode plate 130 through the hole 112. In addition, a second surface (or a bottom surface) 122 of the insulating layer 120 that is opposite to the first surface 121 may be in contact with the second electrode plate 140. To ensure that the internal short-circuit device 100 induces the intended internal short-circuit, the positions of the short-circuit inducing portion 132, the insulating layer 120, and the second electrode plate 140 may need to be properly aligned. To facilitate the alignment, the insulating layer 120 may have adhesive properties, such as those of insulation wax, which can adhere to the short-circuit inducing portion 132 or the second electrode plate 140. Alternatively, at least a portion of a contact area between the first surface 121 of the insulating layer 120 and the short-circuit inducing portion 132 may be coated with an adhesive to secure the insulating layer 120 and the short-circuit inducing portion 132 together. Additionally or alternatively, at least a portion of a contact area between the second surface 122 of the insulating layer 120 and the second electrode plate 140 may be coated with an adhesive to secure the insulating layer 120 and the second electrode plate 140 together.

In one embodiment, the thickness of the insulating layer 120 may be set to be greater than the thickness of the separator 150 in order to maintain an insulation state prior to a short-circuit and to facilitate a subsequent short-circuit. Specifically, the thickness of the insulating layer 120 may range from 0.01 to 0.1 mm in order to maintain insulation performance. If the thickness of the insulating layer 120 is less than 0.01 mm, an internal short-circuit may occur at an undesired time because the thickness of the insulating layer 120 is too thin and is easily destroyed by a small amount of friction or pressure. On the other hand, if the thickness of the insulating layer 120 is greater than 0.1 mm, an internal pressure of the battery may be increased due to the volume of the internal short-circuit device 100, and some of insulation wax constituting the insulating layer 120 may remain even after the insulating layer 120 is melted, which may interfere with the intended induction of the internal short-circuit.

In one embodiment, the area of the insulating layer 120 may exceed the area of the cut-out portion 152 of the separator 150. For example, if the length of the cut-out portion 152 ranges from 3 mm to 9 mm, the length of the insulating layer 120 may range from 4 mm to 10 mm. The insulating layer 120 may be closely adhered to the separator 150 and the second electrode plate 140 to prevent additional breakage of the separator 150 when an external force is applied to the internal short-circuit device 100.

The area or length of the cut-out portion 152 and the corresponding insulating layer 120 may be freely adjusted depending on the experimental conditions for the internal short-circuit and the need to control the performance of the battery. For example, if there are a plurality of cut-out portions 152 and a plurality of insulating layers 120 in corresponding areas on the second electrode plate 140, the areas or lengths of the respective cut-out portions 152 or the areas or lengths of respective insulating layers 120 may be different.

Referring to FIG. 2, when the temperature of the battery including the internal short-circuit device increases, the insulating layer 220 may melt, causing the short-circuit inducing portion 132 of the first electrode plate 130 and the second electrode plate 140 to be electrically connected. This may cause an internal short-circuit to occur at the cut-out portion 152 of the separator 150. In other words, when the temperature of the battery rises above a certain threshold, for example, by external heating during safety testing of the battery or as result of heat generation due to chemical reactions during the actual charging and discharging process of the battery, the insulating layer 220 may melt.

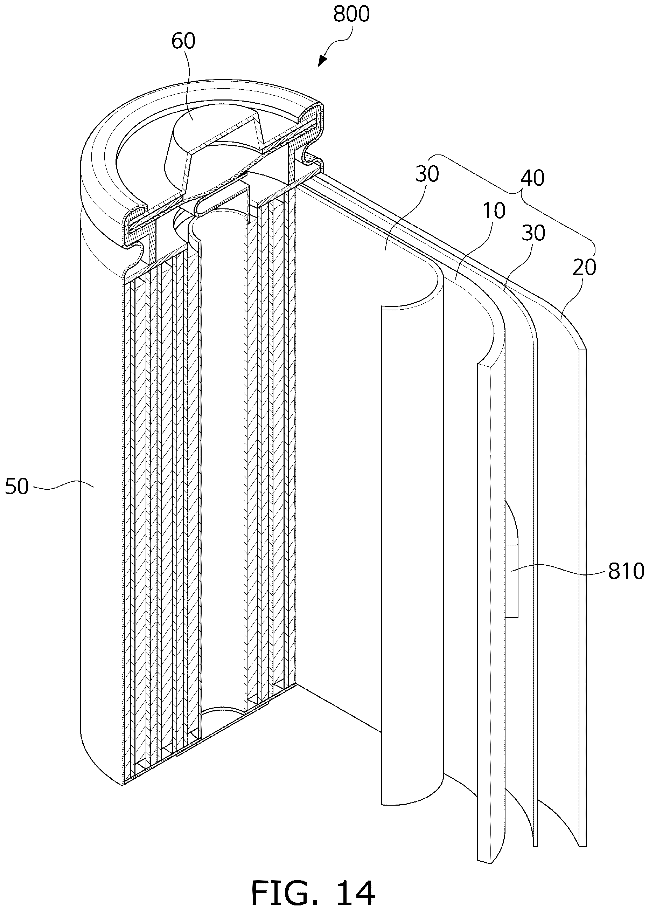

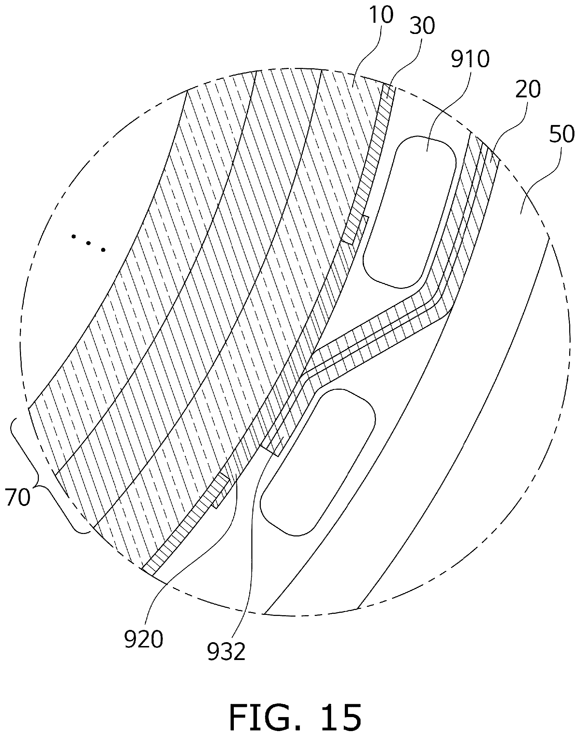

After the insulating layer 220 melts, the external pressure applied to the internal short-circuit device causes the first electrode plate 130 to come into contact with and be electrically connected to the second electrode plate 140, resulting in the internal short-circuit. If the battery has not reached a certain temperature, the insulating layer 120 acts as an insulator similar to the separator 150, allowing the battery to be freely charged and discharged. The structure of the battery that generates the external pressure will be described below with respect to FIGS. 14 and 15.

The insulating layer 120 may be made of an insulation wax, and the melting point of the insulation wax may be between 45 °C and 70 °C. If the melting point of the insulation wax is less than 45 °C, an internal short-circuit may occur under undesirable circumstances depending on the surrounding environment. On the other hand, if the melting point of the insulation wax is greater than 70°C, the battery may experience abnormal reactions due to side reactions from a heating process before the internal short-circuit occurs, making it difficult to observe the pure effect of the internal short-circuit.

In one embodiment, the insulating layer 120 may be made of a paraffin-based compound having 1 to 50 carbon atoms. The paraffin-based compound may include paraffin wax or liquid paraffin composed of saturated hydrocarbons represented by the formula CH₃(CH₂)ₙCH₃, and may refer to a wax that is characterized by low reactivity and possess waterproof and electrical insulating properties. Further, other additives may be included in the insulating layer 120 as long as the additives do not compromise the properties of the paraffin wax or the liquid paraffin and do not affect the operational mechanism of the battery.

In another embodiment, the insulating layer 120 may be made of a hydrocarbon compound including an insoluble alcohol fatty acid ester or a solid alkane. The material constituting the insulating layer 120 may be freely selected based on the set temperature at which the short circuit is intended to occur as long as the material is capable of electrically insulating the first electrode plate 130 from the second electrode plate 140 and is not involved in chemical reactions of the battery.

According to some embodiments of the present disclosure, the internal short-circuit mode, which most frequently occurs due to direct contact between the positive electrode and the negative electrode, can be accurately implemented by heating at a relatively low temperature and without external deformation of the battery. Additionally, the short circuit between the positive electrode and the negative electrode of an actual cell can be reproduced without the need for a separate metallic electrical short path. This allows for precise safety evaluation when an internal short-circuit occurs during the battery development process, thereby improving the reliability of the battery and the reproducibility of the safety device.

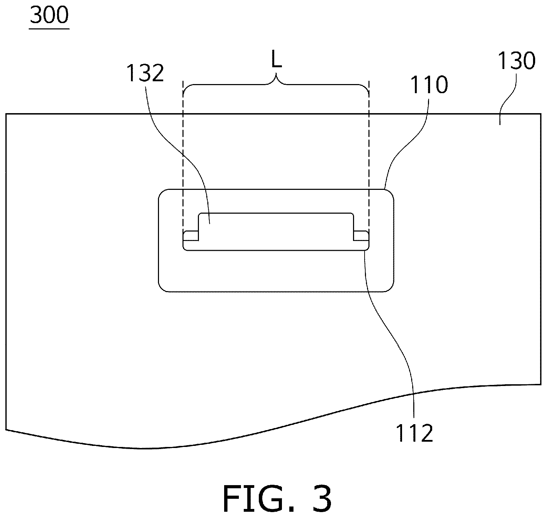

FIG. 3 is a schematic diagram illustrating an internal short-circuit device 300 according to an embodiment of the present disclosure.

In this embodiment, the short-circuit inducing portion 132 may be produced by cutting a portion of the first electrode plate 130. Referring to FIG 3, the short-circuit inducing portion 132 according to the present embodiment may be made by cutting a portion of the first electrode plate 130 and then inserting the cut-out portion into the hole 112 of the insulating member 110. The method of cutting a portion of the first electrode plate 130 includes, but is not limited to, a perforation cutting method suitable for minimizing damage to uncut portions of the first electrode plate 130 and the separator 150.

The length L of the hole 112 may correspond to the length of the short-circuit inducing portion 132. For example, the length L of the hole 112 may correspond to or be greater than the length of the short-circuit inducing portion 132 such that one end of the short-circuit inducing portion 132 passes through the hole 112 and contacts the insulating layer 120.

The width of the hole 112 may correspond to the thickness of the short-circuit inducing portion 132. For example, the width of the hole 112 may correspond to or be greater (longer) than the thickness of the short-circuit inducing portion 132 such that one end of the short-circuit inducing portion 132 passes through the hole 112 and contacts the insulating layer 120.

According to the configuration, the area of the hole 112 may correspond to or be larger than the cross-sectional area of the short-circuit inducing portion 132. However, if the area of the hole 112 is much larger than the cross-sectional area of the short-circuit inducing portion 132, it may become difficult to prevent additional breakage of the separator 150 and to effectively guide the position of the short-circuit inducing portion 132.

The lengths, widths, or areas of the short-circuit inducing portion 132 and the corresponding hole 112 may be adjusted based on experimental conditions and the need to control the performance of the battery. For example, if a single battery contains multiple short-circuit inducing portions 132, the length, width, or area of each hole 112 may be varied to match the length, width, or area of the corresponding short-circuit inducing portion 132.

According to some embodiments of the present disclosure, it is possible to provide an internal short-circuit device that allows for the adjustment of short-circuit resistance for conducting battery safety tests. This structure enables the reproduction of various internal short-circuit modes within the battery, including providing the internal short-circuit device at different locations, in different shapes, and with different lengths.

FIGS. 4 to 6 are diagrams illustrating short-circuit inducing portions 412, 422, and 432, according to an embodiment of the present disclosure.

Referring to FIG. 4, a short-circuit inducing portion 412 may be a portion of the first electrode plate 130 that is electrically connected to the first electrode plate 130 and may include the same configuration and be made of the same material as the first electrode plate 130. The short-circuit inducing portion 412 may include a substrate 415, an upper active material layer 416 formed on a top surface of the substrate 415, and a lower active material layer 417 formed on a bottom surface of the substrate 415.

In a case where the first electrode plate is a negative electrode, the active material applied to the upper active material layer 416 and the lower active material layer 417 may be a negative active material such as graphite or carbon. In a case where the first electrode plate is a positive electrode, the active material applied to the upper active material layer 416 and the lower active material layer 417 may be a positive active material such as a transition metal oxide (e.g., LiCoO₂, LiNiO₂, LiMn₂O₄).

In this embodiment, the lower active material layer 417 of the short-circuit inducing portion 412 may be in contact with the insulating layer 120.

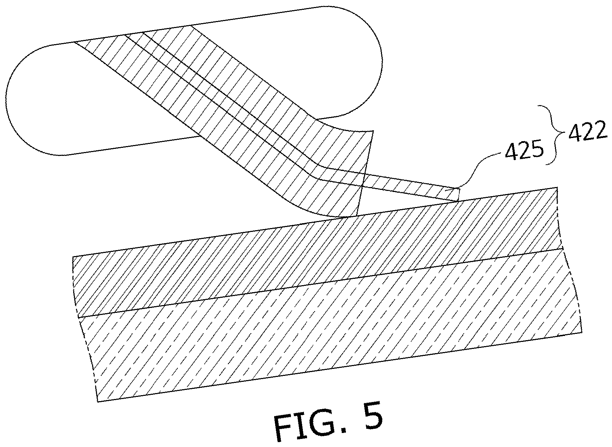

Referring to FIG. 5, a short-circuit inducing portion 422 may include an uncoated portion 425 where the substrate is exposed to outside of the rest of the short-circuit inducing portion 422. In this embodiment, the short-circuit inducing portion 422 of the first electrode plate includes a substrate, an upper active material layer formed on a top surface of the substrate, and a lower active material layer formed on a bottom surface of the substrate. The substrate including the uncoated portion 425 may extend longer than the upper active material layer and the lower active material layer such that the uncoated portion 425 contacts the insulating layer.

In this embodiment, if necessary, before selectively contacting the short-circuit inducing portion 422 with the insulating layer, the upper active material layer and the lower active material layer of the short-circuit inducing portion 422 may be removed to expose the substrate of the short-circuit inducing portion 422 and form the uncoated portion 425.

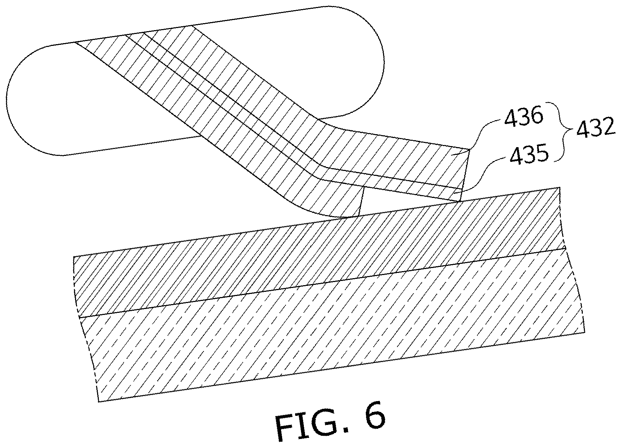

Referring to FIG. 6, the short-circuit inducing portion 432 may include a substrate 435 and an upper active material layer 436 formed on a top upper surface of the substrate 435. In this embodiment, before contacting the short-circuit inducing portion 432 with the insulating layer, the lower active material layer of the short-circuit inducing portion 432 may be removed to expose the substrate of the short-circuit inducing portion 432 on the side that contacts the insulating layer.

FIGS. 7 to 9 are diagrams illustrating the shapes of an insulating member and a hole according to an embodiment of the present disclosure.

Referring to FIG. 7, an insulating member 516 may guide a short-circuit inducing portion 514 such that the short-circuit inducing portion 514 is spaced apart from the first electrode plate 512 and in contact with an insulating layer. Specifically, the short-circuit inducing portion 514 may pass through a hole 518 of the insulating member 516 so that one end of the short-circuit inducing portion 514 can contact the insulating layer.

The length of the hole 518 may be determined based on the length of a cut-out portion in the separator, which exposes the second electrode plate, and the length of the short-circuit inducing portion 514 corresponding to the cut-out portion. The lengths, areas, or shapes of the hole 518, the cut-out portion, and the short-circuit inducing portion 514 may be modified based on experimental conditions, the shape of the short-circuit to be reproduced, and the need to adjust performance of the battery.

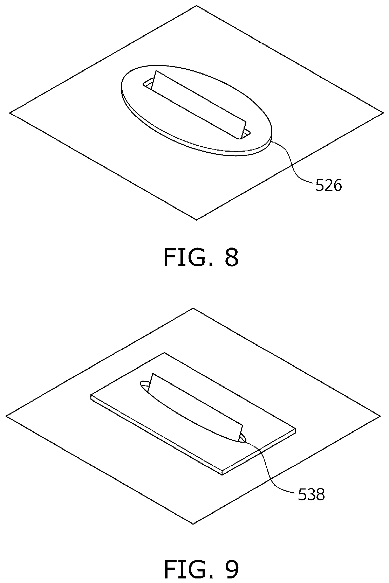

In one embodiment, the shape of the insulating member 516 may be rectangular. Referring to FIG. 8, in another embodiment, an insulating member 526 may be circular shaped. Thus, in the present disclosure, the shapes of the insulating members 516 and 526 are not limited to a specific shape so long as the insulating members 516 and 526 contain the holes 518 and 538, respectively.

In an embodiment, the shape of the hole 518 may be rectangular. Referring to FIG. 9, in another embodiment, the shape of a hole 538 may be circular. In such a case, the diameter (or the major axis in the case of an ellipse) of the hole 538 may be determined based on the length of the short-circuit inducing portion. The diameter (or the major axis in the case of an ellipse) of the hole 538 may correspond to or be greater than the length of the short-circuit inducing portion such that one end of the short-circuit inducing portion passes through the hole 538 to form a portion that contacts an insulating layer. Thus, in the present disclosure, the shapes of the holes 518 and 538 are not limited to a particular shape, as long as it allows the portions of the short-circuit inducing portions to pass through the holes 518 and 538 and contact the insulating layers.

In an embodiment, the height of the insulating member 516 may range from 0.05 mm to 0.5 mm. In an embodiment, the length of the hole 518 may range from 3 mm to 9 mm.

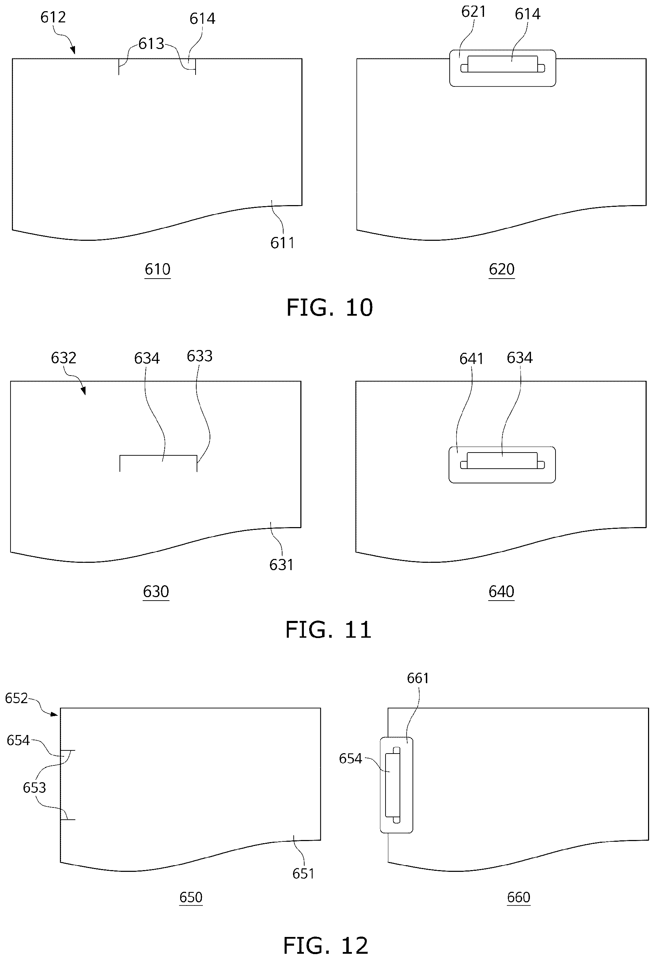

FIGS. 10 to 12 are diagrams illustrating the location of a short-circuit inducing portion according to an embodiment of the present disclosure. The location of the short-circuit inducing portion may be modified based on experimental conditions, the desired location of the short-circuit to be reproduced, and the need to adjust performance of the battery.

Referring to FIG. 10, in an embodiment, a short-circuit inducing portion 614 is located at the end 612 of a first electrode plate 611. In a case where the first electrode plate 611 is included in a winding-type cylindrical battery, the short-circuit inducing portion 614 may be located at the end of the first electrode plate 611 in the direction of winding. As illustrated, in a pre-processing 610 for manufacturing the short-circuit inducing portion 614, a portion of the end 612 of the first electrode plate 611 may be cut to function as the short-circuit inducing portion 614. The distance between cutting lines 613 may correspond to the length of the short-circuit inducing portion 614.

Subsequently, as illustrated, in a post-processing 620 for manufacturing the short-circuit inducing portion 614, a portion of the end 612 of the first electrode plate 611 may pass through the hole of an insulating member 621 to be spaced apart from the first electrode plate 611, thus forming the short-circuit inducing portion 614.

Referring to Fig. 11, in an embodiment, the short-circuit inducing portion 634 is located at a middle region 632 of a first electrode plate 631 (an inner part of the first electrode plate 631). As illustrated, in a pre-processing 630 for manufacturing the short-circuit inducing portion 634, a portion of the middle region 632 of the first electrode plate 631 may be cut to function as the short-circuit inducing portion 634. A cutting line 633 may have a U-shape. In other words, the short-circuit inducing portion 634 may be manufactured by perforating a portion of the first electrode plate 631 in a U-shaped pattern. The distance between the two opposing sides of the U-shape may correspond to the length of the short-circuit inducing portion 634.

Thereafter, as illustrated, in a post-processing 640 for manufacturing the short-circuit inducing portion 634, a portion of the cut first electrode plate 631 may pass through a hole of an insulating member 641 to be spaced apart from the first electrode plate 631, thus forming the short-circuit inducing portion 634.

Referring to FIG. 12, in an embodiment a short-circuit inducing portion 654 is located at a side surface 652 of a first electrode plate 651. In a case where the first electrode plate 651 is included in a winding-type cylindrical battery, the short-circuit inducing portion 654 may be located on the side surface of the first electrode plate 651 in the direction of winding. As illustrated, in a pre-processing 650 for manufacturing the short-circuit inducing portion 654, a portion of the side surface 652 of the first electrode plate 651 may be cut to function as the short-circuit inducing portion 654. The distance between the cutting lines 653 may correspond to the length of the short-circuit inducing portion 654.

Thereafter, as illustrated, in a post-processing 660 for manufacturing the short-circuit inducing portion 654, a portion of the cut side surface 652 of the first electrode plate 651 may be pass through a hole of an insulating member 661 to be spaced from the first electrode plate 651, thus forming the short-circuit inducing portion 654.

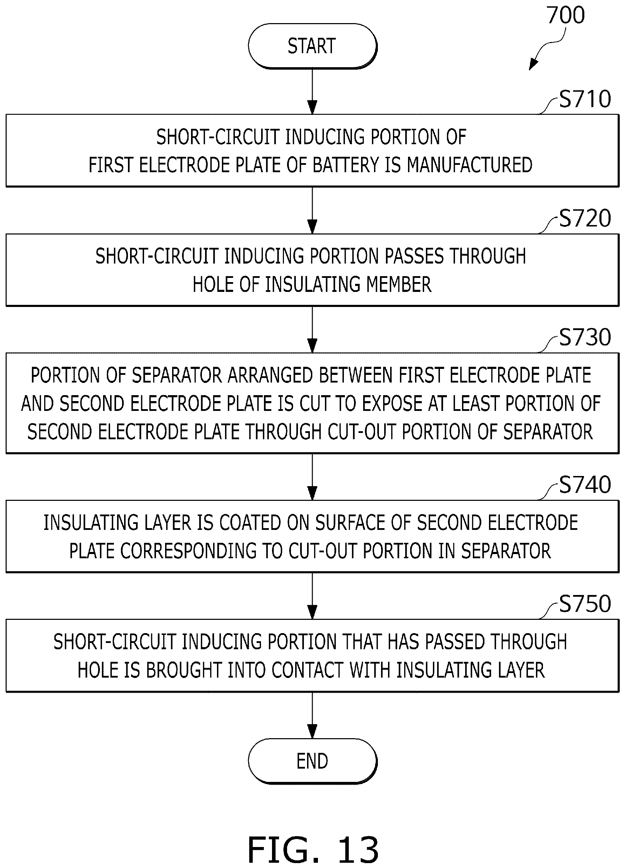

FIG. 13 is a flowchart of a method for manufacturing an internal short-circuit device according to an embodiment of the present disclosure.

A method 700 for manufacturing an internal short-circuit device according to an embodiment of the present disclosure may begin with manufacturing a short-circuit inducing portion of a first electrode plate of a battery (step S710). In one embodiment, a portion of the first electrode plate may be cut in step S710. The method of cutting the portion of the electrode plate is not particularly limited and may include a perforation cutting method to minimize damage to the uncut portions of the first electrode plate.

In an embodiment, in a case where the desired location to produce the short-circuit is located at the outermost part of a jelly roll type battery, the method may include a step of disassembling the jelly roll of the completely assembled battery by separating the completed jelly roll's winding to dismantle the outermost electrode plate before cutting the portion of the first electrode plate. Alternatively or optionally, in a case where the desired location to reproduce the short-circuit is located at a middle region (an inner part) or closer to the winding core of the jelly roll, the method may include a step of winding the jelly roll including the first electrode plate, a separator, and a second electrode plate after manufacturing the internal short-circuit device.

Subsequently, the short-circuit inducing portion may be passed through a hole of an insulating member (step S720).

Next, a portion of the separator arranged between the first electrode plate and the second electrode plate may be cut to expose at least a portion of the second electrode plate through the cut-out portion of the separator (step S730). The method of cutting the portion of the separator is not specifically limited and may include a perforation cutting method to minimize damage to uncut portions of the separator.

Thereafter, an insulating layer may be coated on a surface of the second electrode plate at a position corresponding to the cut-out portion in the separator (step S740). In an embodiment, if the area of the insulating layer is larger than the area of the cut-out portion in the separator, the insulating layer may also be coated on a portion of the separator surrounding the cut-out portion.

Finally, the short-circuit inducing portion that has been passed through the hole may be brought into contact with the insulating layer to manufacture the internal short-circuit device (step S750). In an embodiment, before bringing the short-circuit inducing portion into contact with the insulating layer, the method may further include a step of removing an active material layer of the short-circuit inducing portion to expose a substrate of the short-circuit inducing portion.

FIG. 14 shows a battery according to an embodiment of the present disclosure.

Referring to FIG. 14, a battery 800 may include the internal short-circuit device described above. For convenience in explanation, in FIG. 14 the battery 800 is depicted as a cylindrical battery, but the scope of the present disclosure is not limited to such a battery. Rather, the battery may be any shape, such as a prismatic battery, a pouch battery, and a coin battery. Here, the battery may be a secondary battery type.

The battery 800 may include an electrode assembly 40 having a positive electrode 10, a negative electrode 20 and a separator 30 interposed between the positive electrode 10 and the negative electrode 20. A case 50 accommodates the electrode assembly 40 therein. A sealing member 60 seals the case 50. The positive electrode 10, the negative electrode 20, and the separator 30 may be impregnated with an electrolyte (not shown).

In an embodiment, each of the positive electrode 10 and the negative electrode 20 may include a coated portion that is a region where an active material is coated on a current collector (or a substrate) formed of a thin metal foil and an uncoated portion that is a region where the active material is not coated on the current collector. The positive electrode 10 and the negative electrode 20 may be rolled up with the separator 30 serving as an insulator interposed between the electrodes. However, the scope of the present disclosure is not limited thereto, and the electrode assembly 40 may have a structure in which a plurality of sheet-type positive and negative electrodes 10 and 20 are stacked in alternating manner with separators 30 therebetween.

The case 50 may form the exterior of the battery 800 and may be made of a conductive metal such as aluminum, aluminum alloy, stainless steel (e.g., SUS), or nickel-plated steel. Additionally, the case 50 may provide a space for accommodating the electrode assembly 40. For example, in a case where the battery 800 is a cylindrical battery, the case 50 may have a cylindrical shape. Further, the positive electrode 10, the negative electrode 20, and the separator 30 may be wound in a cylindrical shape.

An internal short-circuit device 810 may be installed between the positive electrode 10 and the separator 30 to induce an internal short-circuit in the battery. Alternatively, although not shown, the internal short-circuit device 810 may be installed between the negative electrode 20 and the separator 30 to induce an internal short-circuit. FIG. 14 illustrates only one internal short-circuit device, but one or more internal short-circuit devices may be installed elsewhere as needed as there is no limitation on the number of internal short-circuit devices that may be included in the batter.

FIG. 15 illustrates a part of a cross-section of a battery according to an embodiment of the present disclosure.

Referring to FIG. 15, the internal short-circuit device of a jelly roll battery 70 according to an embodiment includes an insulating member 910 having a hole through which a short-circuit inducing portion 932 of the negative electrode 20 of the battery passes, and an insulating layer 920 disposed between the insulating member 910 and the positive electrode 10 of the battery.

In this embodiment, if the insulating layer of the internal short-circuit device melts due to a temperature rise in the battery, the negative electrode 20 and the positive electrode 10 may become electrically connected. The battery may be configured by winding the negative electrode 20 and the positive electrode 10 in a stacked state.

When installing the internal short-circuit device before winding the jelly roll 70 of the battery, the location where the internal short-circuit device is installed may be selected. However, the internal short-circuit device may be torn or damaged during the winding process of the electrode assembly. Therefore, the internal short-circuit device may be installed between the positive electrode 10 (or the negative electrode 20) and the separator 30 after the winding process of the electrode assembly has progressed to a certain extent, and then winding can be resumed.

In an embodiment, the internal short-circuit device may be located at the outermost portion or the end portion of the jelly roll 70 being wound by interposing the internal short-circuit device later in the winding process. Through this process, the internal short-circuit device of the battery may be located at the outermost portion of the jelly roll 70 of the battery and placed at the bottom of the case 50. In such a case, the expansion force of the jelly roll 70 and the stress from the case 50 may apply external pressure to the internal short-circuit device. Once the insulating layer melts, the previously applied external pressure may cause the negative electrode 20 and the positive electrode 10 to come into contact with each other and electrically connect, thereby resulting in an internal short circuit.

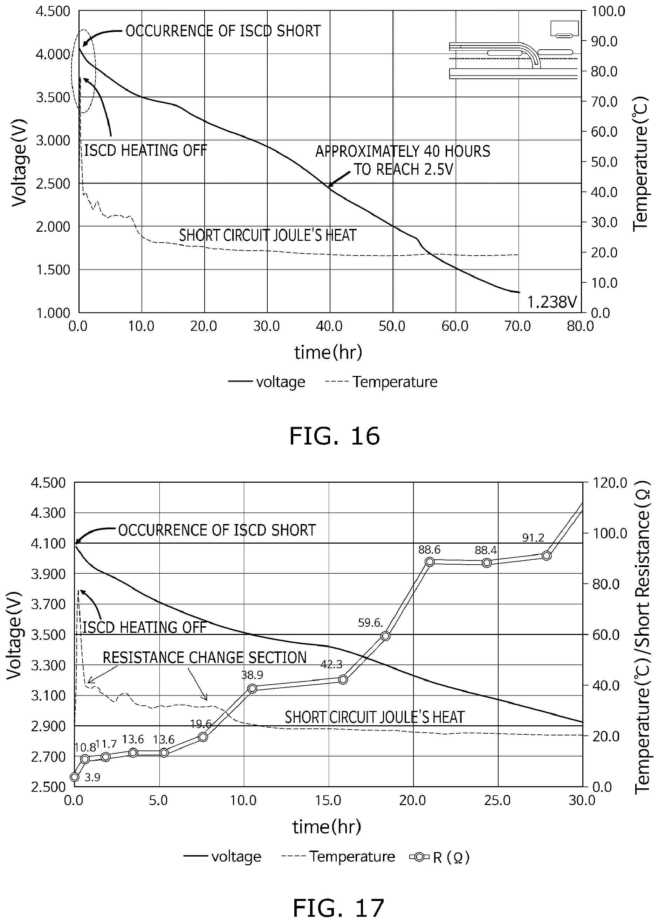

FIGS. 16 and 17 are graphs illustrating the results of verifying the internal short-circuit in a battery according to an embodiment of the present disclosure.

To solve technical problems, a safety evaluation method for the internal short-circuit in the battery according to an embodiment of the present disclosure may include heating the battery to melt the insulating layer (as described above).

Here, the safety evaluation for the internal short-circuit is a test that assesses the battery's resistance to the internal short-circuit among various safety tests of the battery, which is conducted through simulation of the phenomenon that occur when the positive and negative electrodes are short-circuited inside the battery. The safety evaluation method for the internal short circuit according to an embodiment of the present disclosure may be initiated by the steps of manufacturing the internal short-circuit device and manufacturing the battery by mounting and sealing the electrode assembly containing the internal short-circuit device in the battery case. Subsequently, the battery may be heated or further charged to raise the internal temperature of the battery. When the internal temperature of the battery reaches a specified level, the insulating layer of the internal short-circuit device melts, causing an internal short-circuit. Afterwards, the changes in the battery, such as voltage change during discharge, rupture occurrence, and temperature, are evaluated. Generally, when the internal short-circuit occurs, the battery discharges, causing the internal voltage to drop, and the evaluation continues until the voltage drops below a certain threshold.

Referring to a graph shown in FIG. 16, it is observed that during the initial 30 minutes, the battery was heated, causing the insulating layer of the internal short-circuit device to melt. This led to the occurrence of an internal short circuit, resulting in the battery entering a low voltage mode. Consequently, it is observed that the voltage gradually decreased from above 4.0V, and after approximately 70 hours, it dropped to 1.238V.

Referring to a graph shown in FIG. 17, Ohm's law may be used to calculate the internal resistance of the battery from the measured values of the dropped voltage. Through the obtained data, the timing and characteristics of resistance changes can be identified in the event of an internal short-circuit, thereby improving the safety of the battery in the event of the internal short-circuit.

According to embodiments of the present disclosure, the safety evaluation method of a battery according to the present disclosure can improve the reliability and accuracy of the safety evaluation by using an internal short-circuit device so that the desired internal short circuit can be performed regardless of the type of battery.

Further, according to some embodiments of the present disclosure, the safety evaluation method of a battery according to the present disclosure can implement a low-voltage mode of the battery caused by an internal short-circuit by implementing an actual short path. Furthermore, in the low-voltage mode of the battery, the sectional short-circuit resistance can be calculated based on the amount of voltage reduction over time, and the degree of Joule heating corresponding to the calculated internal short-circuit resistance can be determined. This provides a method to evaluate and predict the safety of a battery, thereby increasing the reliability of evaluations to develop or implement safety devices.

However, the present disclosure is not limited to the above embodiments, for example, the battery case may be configured in various shapes, such as a circular shape and a pouch shape. Further, the battery case may be made of a metal, such as aluminum, aluminum alloy, or nickel-plated steel, a laminated film, or plastic (e.g., in a pouch-type embodiment).

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

### [DESCRIPTION OF SOME REFERENCE SYMBOLS]

100: internal short-circuit device
110: insulating member
112: hole
120: insulating layer
121: first surface
122: second surface
130: first electrode plate
132: short-circuit inducing portion
140: second electrode plate
150: separator
152: cut-out portion

## Claims

1. An internal short-circuit device (100, 200, 300, 810) comprising:
an insulating member (110, 516, 526, 621, 641, 661, 910) including a hole (112, 518, 538);
a short-circuit inducing portion (132, 412, 422, 432, 514, 614, 634, 654, 932) of a first electrode plate (130, 512, 611, 631, 651) for a battery (800) extending through the hole (112, 518, 538) in the insulating member (110, 516, 526, 621, 641, 661, 910); and
an insulating layer (120, 220, 920) disposable between the insulating member (110, 516, 526, 621, 641, 661, 910) and a second electrode plate (130, 140) for the battery (800),
wherein a first surface (121) of the insulating layer (120, 220, 920) is in contact with the short-circuit inducing portion (132, 412, 422, 432, 514, 614, 634, 654, 932) of the first electrode plate (130, 512, 611, 631, 651), and
wherein a second surface (122) of the insulating layer (120, 220, 920), which is opposite to the first surface (121), is contactable with the second electrode plate (130, 140).

2. The internal short-circuit device (100, 200, 300, 810) as claimed in claim 1, wherein a separator (150) for the battery (800) is disposable between the first electrode plate (130, 512, 611, 631, 651) and the second electrode plate (130, 140) for the battery (800), and
wherein the insulating layer (120, 220, 920) is coatable on a surface of the second electrode plate (130, 140) corresponding to a cut-out portion (152) of the separator (150).

3. The internal short-circuit device (100, 200, 300, 810) as claimed in claim 2, wherein at least a portion of the insulating member (110, 516, 526, 621, 641, 661, 910) is disposable between the first electrode plate (130, 512, 611, 631, 651) and the separator (150).

4. The internal short-circuit device (100, 200, 300, 810) as claimed in any one of claims 1 to 3, wherein the short-circuit inducing portion (132, 412, 422, 432, 514, 614, 634, 654, 932) is a portion cut from the first electrode plate (130, 512, 611, 631, 651).

5. The internal short-circuit device (100, 200, 300, 810) as claimed in any one of claims 1 to 4, wherein the short-circuit inducing portion (132, 412, 422, 432, 514, 614, 634, 654, 932) of the first electrode plate (130, 512, 611, 631, 651) comprises a substrate (415, 435), an upper active material layer (416, 436) disposed on a top surface of the substrate (415, 435), and/or a lower active material layer (417) disposed on a bottom surface of the substrate (415, 435), and
wherein the substrate (415, 435) is in contact with the insulating layer (120, 220, 920).

6. The internal short-circuit device (100, 200, 300, 810) as claimed in any one of claims 1 to 5, wherein the short-circuit inducing portion (132, 412, 422, 432, 514, 614, 634, 654, 932) of the first electrode plate (130, 512, 611, 631, 651) comprises a substrate (415, 435), an upper active material layer (416, 436) disposed on a top surface of the substrate (415, 435), and/or a lower active material layer (417) disposed on a bottom surface of the substrate (415, 435), and
wherein the lower active material layer (417) is in contact with the insulating layer (120, 220, 920) and/or wherein the upper active material layer (416, 436) is in contact with the insulating layer (120, 220, 920).

7. The internal short-circuit device (100, 200, 300, 810) as claimed in any one of claims 1 to 6, wherein the insulating layer (120, 220, 920) is formed from a paraffin-based compound having 1 to 50 carbon atoms.

8. The internal short-circuit device (100, 200, 300, 810) as claimed in any one of claims 1 to 7, wherein a melting point of the insulating layer (120, 220, 920) is from 45 °C to 70 °C.

9. The internal short-circuit device (100, 200, 300, 810) as claimed in any one of claims 1 to 8, wherein the battery (800) is formable by winding the first electrode plate (130, 512, 611, 631, 651) and the second electrode plate (130, 140) in a stacked state such that the first electrode plate (130, 512, 611, 631, 651) and the second electrode plate (130, 140) are electrically connected to each other when the insulating layer (120, 220, 920) is melted.

10. The internal short-circuit device (100, 200, 300, 810) as claimed in any one of claims 1 to 9, wherein a length of the hole (112, 518, 538) is from 3 mm to 9 mm.

11. The internal short-circuit device (100, 200, 300, 810) as claimed in any one of claims 1 to 10, wherein a height of the insulating member (110, 516, 526, 621, 641, 661, 910) 110 is from 0.05 mm to 0.5 mm.

12. The internal short-circuit device (100, 200, 300, 810) as claimed in any one of claims 1 to 11, wherein
the short-circuit inducing portion (132, 412, 422, 432, 514, 614, 634, 654, 932) is located at an end (612) of the first electrode plate (130, 512, 611, 631, 651), the short-circuit inducing portion (132, 412, 422, 432, 514, 614, 634, 654, 932) is located at a side surface (652) of the first electrode plate (130, 512, 611, 631, 651), or wherein
the short-circuit inducing portion (132, 412, 422, 432, 514, 614, 634, 654, 932) is located at a middle region (632) of the first electrode plate (130, 512, 611, 631, 651).

13. The internal short-circuit device (100, 200, 300, 810) as claimed in claim 12, wherein the short-circuit inducing portion (132, 412, 422, 432, 514, 614, 634, 654, 932) is formed by perforating a portion of the first electrode plate (130, 512, 611, 631, 651) into a U-shape.

14. A battery (800) comprising the internal short-circuit device (100, 200, 300, 810) as claimed in any one of the claims 1 to 13.

15. A method of manufacturing an internal short-circuit device (100, 200, 300, 810), the method comprising:
forming (S710) a short-circuit inducing portion of a first electrode plate of a battery;
passing (S710) the short-circuit inducing portion through a hole in an insulating member;
cutting (S730) a portion of a separator arranged between the first electrode plate and a second electrode plate to expose at least a portion of the second electrode plate through the cut-out portion of the separator;
coating (S740) an insulating layer on a surface of the second electrode plate at a position corresponding to the cut-out portion of the separator; and
contacting (S750) the short-circuit inducing portion, which has passed through the hole, to the insulating layer.
